# EUROPEAN PATENT APPLICATION

(11) **EP 4 577 024 A1**
(43) Date of publication of application: **25.06.2025**
(21) Application number: 23855062.8
(22) Date of filing: 21.07.2023
(51) Int. Cl.: H10K 71/00, H10K 71/16, C23C 14/04

(54) **DEPOSITION MASK FOR OLED PIXEL DEPOSITION**

(30) Priority: 17.08.2022 KR 20220102490
(71) Applicant: LG INNOTEK CO. LTD, Gangseo-gu Seoul 07796 (KR)
(72) Inventor: LEE, Seung Heon, Seoul 07796 (KR); UM, Tae In, Seoul 07796 (KR)
(74) Representative: M. Zardi & Co S.A.
(86) International application number: PCT/KR2023/010574
(87) International publication number: WO 2024/039091

(57) **Abstract**

A deposition mask comprising; a metal plate including a deposition region and a non-deposition region, wherein the deposition region includes at least one effective portion; wherein the effective portion includes a plurality of unit through-holes, wherein the unit through-holes include a small surface hole formed on a first surface of the metal plate; a large surface hole formed on a second surface of the metal plate; and a connecting portion connecting the small surface hole and the large surface hole, wherein the unit through-hole includes a first width defined as a width in a first direction; and a second width defined as a width in a second direction, wherein the first width and the second width are different, wherein a rib is disposed between unit through-holes adjacent in the first direction, wherein an island portion is disposed between the unit through-holes adjacent in the second direction, wherein a height of the small surface hole of the unit through-hole in the second direction is smaller than a height of the small surface hole of the unit through-hole in the first direction.

## Description

### [Technical Field]

An embodiment relates to a deposition mask for OLED pixel deposition.

### [Background Art]

Display devices are applied to various devices. For example, the display device is applied to a small device such as a smart phone or a tablet PC. Alternatively, the display device is applied to a large-sized device such as a TV, monitor, or public display. Recently, the demand for ultra-high definition (UHD) of 500 pixels per inch (PPI) or more is increasing. Accordingly, display devices having high resolution are being applied to small devices and large devices.

Display devices are classified into liquid crystal display (LCD) and organic light emitting diode (OLED) according to driving methods.

The LCD is a display device driven using liquid crystal. In addition, OLED is a display device driven by using an organic material.

The OLED can express an infinite contrast ratio, has a response speed that is 1000 times faster than LCD, and has an excellent viewing angle. Accordingly, the OELD is attracting attention as a display device that can replace the LCD.

The OLED includes a light emitting layer. The light emitting layer includes an organic material. The organic material is deposited on the substrate using a deposition mask. The deposition mask may include an open mask (OM) or a fine metal mask (FMM). A deposition pattern corresponding to a pattern formed on a deposition mask is formed on the substrate. Accordingly, the deposition pattern may serve as a pixel.

The open mask is a thin plate that forms a deposition pattern only at a specific location when manufacturing an OLED. The open mask is used in a deposition process of forming a light emitting layer thereon after a backplane is completed in a display manufacturing process. That is, the open mask is a mask that does not cover a portion within an operating range of the display in order to deposit the entire surface of the display. Therefore, the open mask is used when depositing a light emitting layer with a light emitting material of one color.

On the other hand, the fine metal mask is used to change the color of the sub-pixels of the light emitting layer. Accordingly, the fine metal mask includes ultra-fine holes. The process of using the fine metal mask requires a multi-step deposition process. Therefore, the process requires accurate alignment. Accordingly, the process using the fine metal mask is more difficult than the process using the open mask.

When the light emitting layer of the OLED is deposited using an open mask, only a single-color light emitting layer is formed. Therefore, separate color filters are required to implement various colors. On the other hand, when using the fine metal mask, an RGB light emitting layer may be formed. Therefore, a separate color filter is not required. That is, the technique using the fine metal mask has a high degree of difficulty. However, compared to the method using an open mask, light efficiency is good because a filter for blocking light is not required.

The fine metal mask is generally made of an Invar alloy metal plate including iron (Fe) and nickel (Ni). Through-holes are formed through one surface and the other surface of the metal plate. The through-hole is formed at a position corresponding to the pixel pattern. Accordingly, red, green, and blue organic materials may pass through the through-hole of the metal plate and be deposited on the deposition substrate. Accordingly, a pixel pattern may be formed on the deposition substrate.

Meanwhile, the fine metal mask includes a small surface hole formed on one surface of the metal plate and a large surface hole formed on the other surface of the metal plate. The small face hole and the large surface hole are connected by a connecting portion. As a result, the through-hole is formed.

The organic material is sprayed in the direction of the fine metal mask. The organic material is deposited on the deposition substrate using the large surface hole as an inlet and the small surface hole as an outlet.

The through-hole may have a different angle of the inner surface of the large surface hole depending on the direction. Accordingly, when the height of the small surface hole is the same in all directions, organic material deposition efficiency may be reduced.

In addition, when the height of the small surface hole is different in each direction, the strength of the fine metal mask is different in each direction. Accordingly, the fine metal mask may be bent in one direction.

Accordingly, there is a need for a deposition mask having a new structure capable of solving the above problems.

### [Disclosure]

### [Technical Problem]

The embodiment provides a deposition mask for OLED pixel deposition with improved deposition efficiency and rigidity.

### [Technical Solution]

A deposition mask comprising; a metal plate including a deposition region and a non-deposition region, wherein the deposition region includes at least one effective portion; wherein the effective portion includes a plurality of unit through-holes, wherein the unit through-holes include a small surface hole formed on a first surface of the metal plate; a large surface hole formed on a second surface of the metal plate; and a connecting portion connecting the small surface hole and the large surface hole, wherein the unit through-hole includes a first width defined as a width in a first direction; and a second width defined as a width in a second direction, wherein the first width and the second width are different, wherein a rib is disposed between unit through-holes adjacent in the first direction, wherein an island portion is disposed between the unit through-holes adjacent in the second direction, wherein a height of the small surface hole of the unit through-hole in the second direction is smaller than a height of the small surface hole of the unit through-hole in the first direction.

### [Advantageous Effects]

The deposition mask according to the first embodiment includes unit through-holes. The unit through-hole has different widths in the first and second directions.

Accordingly, the large surface hole of the unit through-holes may have different heights and inclination angles in the first and second directions. Accordingly, deposition efficiency of the deposition mask may decrease. In addition, since the strength of the deposition mask varies depending on the direction, the deposition mask may be bent in one direction.

Therefore, in the deposition mask according to the first embodiment, the height of the small surface hole is different depending on the direction. In detail, the height of the small surface hole is large in a direction where the height of the large surface hole is small. Further, the height of the small surface hole is small in a direction where the height of the large surface hole is large. Accordingly, it is prevented that the strength of the deposition mask varies depending on the direction.

Further, the height of the small surface hole is large in a direction where the inclination angle of the large surface hole is small. Further, the height of the small surface hole is small in a direction where the inclination angle of the large surface hole is large. Accordingly, deposition uniformity of the deposition mask is improved.

Therefore, the deposition mask according to the first embodiment has improved deposition efficiency and reliability.

A deposition mask according to the second embodiment includes unit through-holes. The unit through-hole has different widths in the first direction and in the second direction. In addition, rib having different widths in the first and second directions are disposed between adjacent unit through-holes.

Accordingly, deposition uniformity of the deposition mask may be reduced. In addition, the strength of the deposition mask may vary depending on the direction.

Therefore, the height of the small surface hole and the large surface hole are different depending on the direction. In detail, the height of the large surface hole is small in a direction where the width of the rib is small. In addition, the height of the small surface hole is large in a direction where the width of the rib is small. In addition, the height of the large surface hole is large in a direction where the width of the rib is large. In addition, the height of the small surface hole is small in a direction where the width of the rib is large.

Accordingly, it is possible to prevent the strength of the deposition mask from being varied depending on the direction. In addition, a sufficient amount of organic material can be accommodated in the large surface hole having a large width of the rib.

Therefore, the deposition mask according to the second embodiment has improved deposition efficiency and reliability.

The deposition mask according to the third embodiment includes unit through-holes. The unit through-holes have different widths in the third and fourth directions. In addition, island portions having different widths and/or areas in the third and fourth directions are disposed between adjacent unit through-holes.

Accordingly, deposition uniformity of the deposition mask may be reduced. In addition, the strength of the deposition mask may vary depending on the direction.

Therefore, the height of the small surface hole and the large surface hole are different depending on the direction. In detail, the height of the large surface hole is small in a direction where the width and/or area of the island portion is small. In addition, the height of the small surface hole is large in a direction where the width and/or area of the island portion is small. In addition, the height of the large surface hole is large in a direction where the width and/or area of the island portion is large. In addition, the height of the small surface hole is small in a direction where the width and/or area of the island portion is large.

Accordingly, it is possible to prevent the strength of the deposition mask from being varied depending on the direction. In addition, a sufficient amount of organic material can be accommodated in the large surface hole having a large width and/or area of the island portion.

Therefore, the deposition mask according to the third embodiment has improved deposition efficiency and reliability.

### [Description of Drawings]

FIG. 1 is a view showing a combination of a deposition mask and a frame according to an embodiment.
FIG.2 is a cross-sectional view of an organic material deposition apparatus including the deposition mask according to the embodiment.
FIG. 3 is a view illustrating formation of a deposition pattern on a deposition substrate by through-holes of the deposition mask according to the embodiment.
FIG. 4 is a plan view of the deposition mask according to the embodiment.
FIG. 5 is a plan view of an effective portion of the deposition mask according to a first embodiment.
FIG. 6 is a cross-sectional view taken along a region A-A' of FIG. 4.
FIG. 7 is a cross-sectional view taken along a region B-B' of FIG. 4.
FIG. 8 is a view for comparing FIGS. 6 and 7.
FIG. 9 is a plan view of an effective portion of the deposition mask according to a second embodiment.
FIG. 10 is a cross-sectional view taken along a region C-C' of FIG. 9.
FIG. 11 is a cross-sectional view taken along a region D-D' of FIG. 9.
FIG. 12 is a view for comparing FIGS. 10 and 11.
FIG. 13 is a plan view of an effective portion of the deposition mask according to a third embodiment.
FIG. 14 is a cross-sectional view taken along a region E-E' of FIG. 13.
FIG. 15 is a cross-sectional view taken along a region F-F' of FIG. 13;
FIG. 16 is a view for comparing FIGS. 14 and 15.
FIG. 17 is a plan view of an effective portion of the deposition mask according to a fourth embodiment.
FIG. 18 is a cross-sectional view taken along a region G-G' of FIG. 17.
FIG. 19 is a cross-sectional view taken along a region H-H' of FIG. 17.
FIG. 20 is a cross-sectional view taken along a region I-I' of FIG. 17.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a deposition mask according to an embodiment will be described with reference to the drawings.

The deposition mask described below is a fine metal mask capable of forming an RGB pixel pattern on the deposition substrate by depositing red, green, and blue organic materials on the deposition substrate. In addition, the following description does not apply to the open mask.

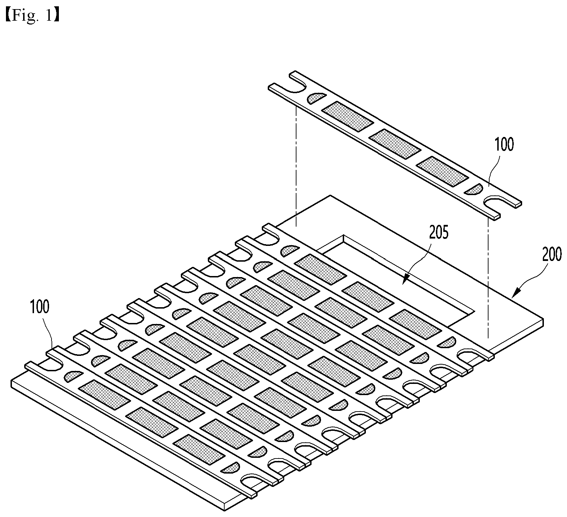

FIGS 1 to 3 are views for explaining a process of depositing an organic material on a deposition substrate 300 using a deposition mask 100 according to an embodiment.

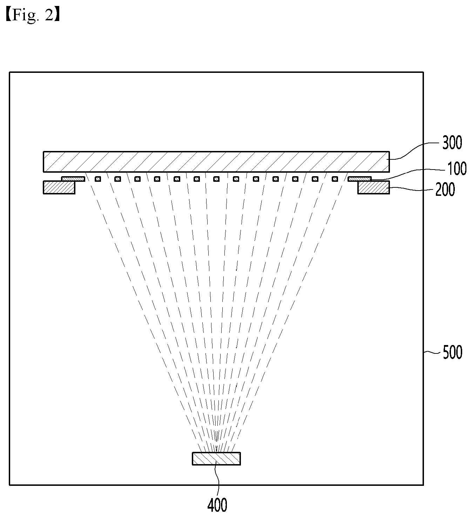

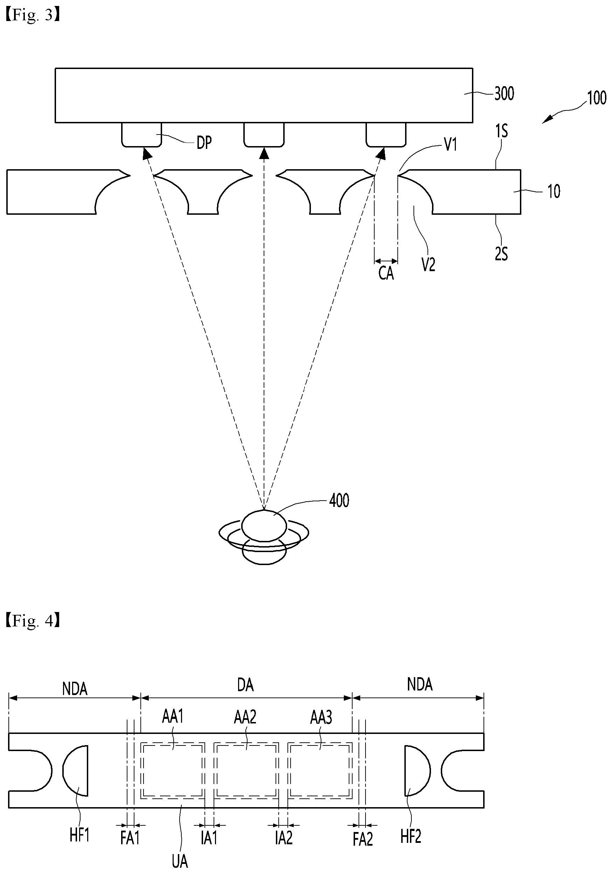

FIG. 1 is a view showing a combination of a deposition mask and a frame according to the embodiment. FIG.2 is a cross-sectional view of an organic material deposition apparatus including the deposition mask according to the embodiment. FIG. 3 is a view illustrating formation of a deposition pattern on a deposition substrate by through-holes of the deposition mask according to the embodiment.

Referring to FIGS. 1 and 2, the organic material deposition apparatus includes a deposition mask 100, a mask frame 200, a deposition substrate 300, an organic material deposition container 400 and a vacuum chamber 500.

The deposition mask 100 includes metal. For example, the deposition mask includes iron (Fe) and nickel (Ni). In detail, the deposition mask includes an invar alloy including iron (Fe) and nickel (Ni).

The deposition mask 100 includes a plurality of through-holes TH. The through-hole is disposed in the effective portion. The through-hole is disposed to correspond to a pixel pattern to be formed on the deposition substrate. The deposition mask 100 includes a non-effective portion other than an effective portion including a deposition region.

The mask frame 200 includes an opening 205. The plurality of through-holes are disposed on a region corresponding to the opening 205. Accordingly, the organic material supplied to the organic material deposition container 400 is deposited on the deposition substrate 300. The deposition mask 100 is disposed and fixed on the mask frame 200. For example, the deposition mask 100 is tensioned with a set tensile force. In addition, the deposition mask 100 is welded and fixed on the mask frame 200.

For example, the non-effective portion of the deposition mask 100 is welded. Accordingly, the deposition mask 100 is fixed on the mask frame 200. Then, the portion protruding out of the mask frame 200 is cut and removed.

The mask frame 200 includes metal having high rigidity. Thus, deformation of the mask frame during the welding process is reduced.

The deposition substrate 300 is a substrate used when manufacturing a display device. For example, an OLED pixel pattern is formed on the deposition substrate 300. Red, green, and blue organic patterns are formed on the deposition substrate 300 to form pixels that are three primary colors of light. That is, an RGB pattern is formed on the deposition substrate 300.

The organic material deposition container 400 is a crucible. The organic material is disposed inside the crucible. The organic material deposition container 400 moves inside the vacuum chamber 500. That is, the organic material deposition container 400 moves in one direction inside the vacuum chamber 500. For example, the organic material deposition container 400 moves in the width direction of the deposition mask 100 inside the vacuum chamber 500.

A heat source and/or current is supplied to the organic material deposition container 400. As a result, the organic material is deposited on the deposition substrate 300.

Referring to FIG. 3, the deposition mask 100 includes a metal plate 10. The metal plate includes a first surface 1S and a second surface 2S. The first surface 1S and the second surface 2S are opposite to each other.

The first surface 1S includes a small surface hole V1. The second surface 2S includes a large surface hole V2. For example, a plurality of small surface holes V1 and a plurality of large surface holes V2 are formed on the first surface 1S and the second surface 2S, respectively.

**In** addition, the deposition mask 100 includes a through-hole TH. The through-hole TH is formed by a connection portion CA connecting the boundary between the small surface hole V1 and the large surface hole V2.

The width of the large surface hole V2 is greater than that of the small surface hole V1. The width of the small surface hole V1 is measured on the first surface 1S of the deposition mask 100. The width of the large surface hole V2 is measured on the second surface 2S of the deposition mask 100.

Also, a width of the connection portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. When the width of the connection portion CA exceeds 33 µm, it is difficult to implement a resolution of 500 PPI or higher. In addition, when the width of the connection portion CA is less than 15 µm, defects may occur during the deposition process.

The small surface hole V1 faces the deposition substrate 300. The small surface hole V1 is disposed close to the deposition substrate 300. Accordingly, the small surface hole V1 has a shape corresponding to a deposition pattern DP.

The large surface hole V2 faces the organic material deposition container 400. Accordingly, the organic material supplied from the organic material deposition container 400 may be accommodated in a wide width by the large surface hole V2. In addition, a fine pattern may be rapidly formed on the deposition substrate 300 by the small surface hole V1.

Accordingly, the organic material accommodated by the large surface hole V2 is deposited on the deposition substrate 300 by the small surface hole V1. Accordingly, any one of red, green, and blue pixel patterns is formed on the deposition substrate 300. Then, the above process is repeated. Accordingly, red, green, and blue pixel patterns are all formed on the deposition substrate 300.

FIG. 4 is a plan view of a deposition mask 100 according to the embodiment.

Referring to FIG. 4, the deposition mask 100 includes a deposition region DA and a non-deposition region NDA.

The deposition region DA is a region for forming the deposition pattern. The deposition region DA includes a pattern region and a non-pattern region. The pattern region is a region including the small surface hole V1, the large surface hole V2, the through-hole TH, and the island portion IS. The non-pattern region is a region that does not include the small surface hole V1, the large surface hole V2, the through-hole TH, and the island portion IS.

Also, the deposition region DA includes a plurality of effective portions AA1, AA2, and AA3. A plurality of deposition patterns may be formed by the effective portion. In detail, the pattern region includes the plurality of effective portions AA1, AA2, and AA3.

The deposition region DA includes a plurality of separation regions IA1 and IA2. Separation regions IA1 and IA2 are disposed between adjacent effective portions. The separation regions IA1 and IA2 are spaced regions between the plurality of effective portions. Adjacent effective portions may be distinguished from each other by the separation regions IA1 and IA2. In addition, one deposition mask 100 may support a plurality of effective portions.

The non-deposition region NDA is a region not involved in deposition. The non-deposition region NDA includes frame fixing regions FA1 and FA2. The frame fixing regions FA1 and FA2 are regions for fixing the deposition mask 100 to the mask frame 200. Also, the non-deposition region NDA may include half-etched portions HF1 and HF2 and an open portion.

The half etching portions HF 1 and HF2 may disperse stress generated when the deposition mask 100 is tensioned.

In addition, the open portion may disperse stress generated when the deposition mask 100 is tensioned. Accordingly, deformation of the deposition mask may be reduced.

As described above, the deposition mask 100 includes the through-hole. The through-hole is a passage through which the organic material moves.

The through-hole is formed by a small face hole, a large surface hole, and a connecting portion. When the shape of the large surface hole is an asymmetrical shape having a plurality of widths, the inclination angle of the inner surface of the large surface hole may be different for each region. That is, the inner surface of the large surface hole in the long width direction and the inner surface of the large surface hole in the short width direction have different inclination angles. Accordingly, when the height of the small surface hole is the same, the deposition rate in the short width direction and the long width direction is different. Accordingly, deposition efficiency of the deposition mask may decrease.

In addition, when the shape of the large surface hole is an asymmetrical shape having a plurality of widths, the height of the large surface hole in the long width direction may be different from the height of the large surface hole in the short width direction. Accordingly, strength of the deposition mask may be different in the long width direction and the short width direction. Accordingly, the deposition mask may be bent in one direction.

Further, when the shape of the large surface hole is an asymmetrical shape having a plurality of widths, the remaining area of the metal plate in the long width direction may be different from the remaining area of the metal plate in the short width direction. Accordingly, strength of the deposition mask may be different in the long width direction and the short width direction. Accordingly, the deposition mask may be bent in one direction.

Hereinafter, the deposition mask capable of solving the above problems will be described.

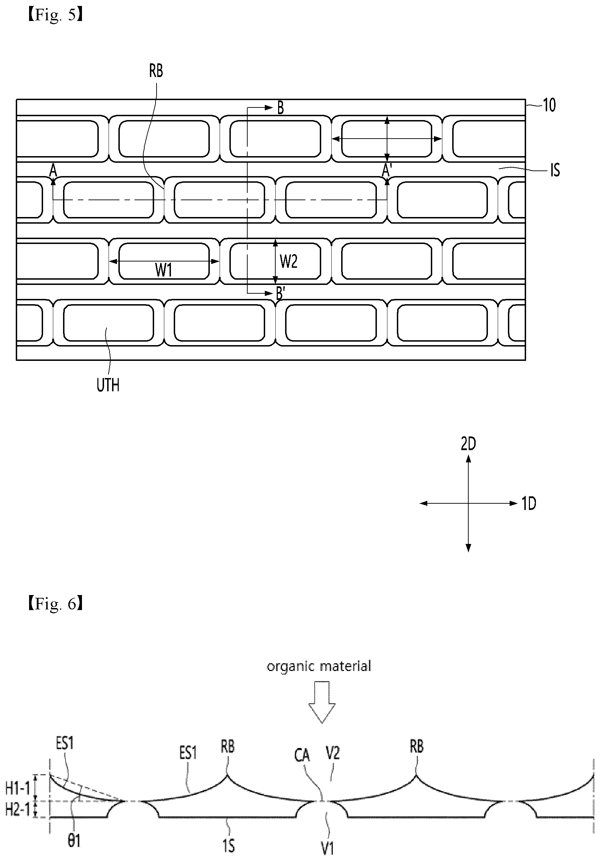

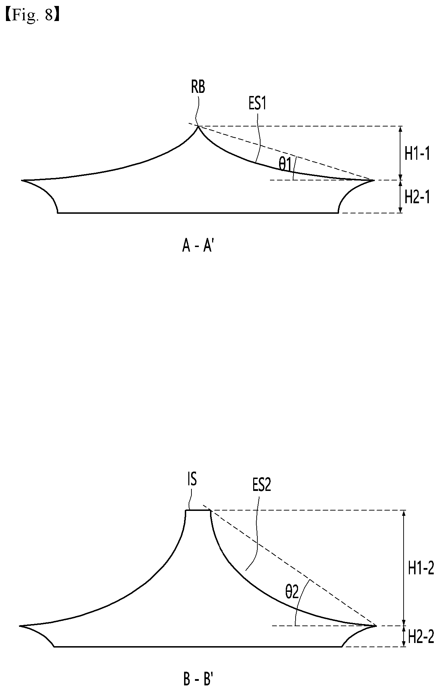

The deposition mask according to the first embodiment will be described with reference to FIGS. 5 to 8.

Referring to FIGS 5 to 8, the deposition mask 100 includes a plurality of through-holes. In detail, the deposition mask 100 includes a plurality of unit through-holes UTH. The unit through-hole UTH is formed by the small surface hole V1, the large surface hole V2 and the connection portion CA.

The unit through-hole UTH includes a first width W1 in a first direction 1D and a second width W2 in a second direction 2D. The first direction 1D and the second direction 2D may be a longitudinal direction or a width direction of the deposition mask 100. For example, the first direction 1D may be a longitudinal direction of the deposition mask 100. Also, the second direction 2D may be a width direction of the deposition mask 100. In addition, the size of the width is defined as the size of the width of the large surface hole V2.

The first width W1 and the second width W2 are different. For example, the first width W1 is greater than the second width W2. Accordingly, the unit through-hole UTH has a long width in the first direction and a short width in the second direction.

A rib RB and an island portion IS are disposed between the plurality of unit through-holes UTH. The rib RB is a region where the metal plate 10 is partially etched. In addition, the island portion IS is a region where the metal plate 10 is not etched. Also, the thickness of the island portion IS is equal to the thickness of the non-deposition region NDA of the metal plate 10.

The rib RB is disposed between unit through-holes UTH adjacent in the first direction 1D. In addition, the island portion IS is disposed between unit through-holes UTH adjacent in the second direction 2D.

Accordingly, the unit through-hole UTH has a height H1-1 of the first large surface hole and height H1-2 of the second large surface hole. The height H1-1 of the first large surface hole is a height in the first direction 1D. The height H1-2 of the second large surface hole is a height in the second direction 2D. The height H1-1 of the first large surface hole and the height H1-2 of the second large surface hole are different. The height H1-1 of the first large surface hole is the height from the connecting portion CA to the rib RB. The height H1-2 of the second large surface hole is the height from the connecting portion CA to the island portion IS.

The rib RB is a region where the metal plate 10 is partially etched. Accordingly, the height H1-2 of the second large surface hole is greater than the height H1-1 of the first large surface hole.

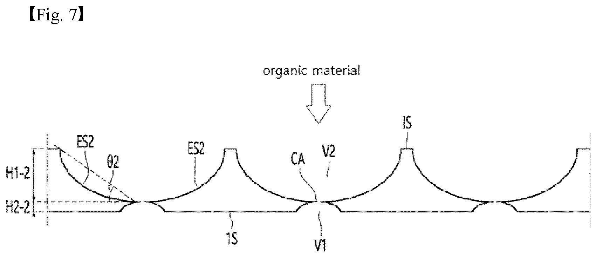

The large surface hole V2 has an inner surface. FIGS. 6 and 7 show that the inner surface of the large surface hole V2 is a curved surface. However, the embodiment is not limited thereto. For example, the inner surface of the large surface hole V2 may be formed as a plane.

The large surface hole V2 includes a plurality of inner surfaces defined according to the direction. Referring to FIG. 6, the large surface hole V2 includes a first inner surface ES1 facing in the first direction. Also, referring to FIG. 7, the large surface hole V2 includes a second inner surface ES2 facing in the second direction.

The first inner surface ES1 and the second inner surface ES2 each have an inclination angle. An imaginary line extending between one end of the connecting portion CA and one end of the large surface hole V2 may be defined. The inclination angle is defined as an acute angle between the imaginary line and the extension line of the connecting portion CA.

The first inner side surface ES1 has a first inclination angle θ1. Also, the second inner surface ES2 has a second inclination angle θ2. The first inclination angle θ1 and the second inclination angle θ2 are different. For example, the second inclination angle θ2 may be greater than the first inclination angle θ1. That is, since the height H1-2 of the second large surface hole is greater than the height H1-1 of the first large surface hole, the second inclination angle θ2 may be greater than the first inclination angle θ1.

The height H1-2 of the second large surface hole is greater than the height H1-1 of the first large surface hole. Also, the second inclination angle θ2 is greater than the first inclination angle θ1.

Accordingly, an angle of the organic material entering the large surface hole in the first direction and an angle of the organic material entering the large surface in the second direction may be different. In addition, the amount of the organic material entering the large surface in the first direction and the amount of the organic material entering the large surface in the second direction may be different. Accordingly, when the heights of the small surface holes in the first direction and the second direction are the same, the organic layer deposited on the deposition substrate may have different thicknesses in each direction. Accordingly, the deposition efficiency of the deposition mask may decrease.

Further, since the heights of the large surface holes in the first direction and the second direction are different, the remaining areas of the metal plates in the first direction and the second direction are different. Therefore, the strength of the deposition mask is different in the first direction and the second direction. Accordingly, since the strength of the deposition mask varies depending on the direction, the deposition mask may be bent in one direction.

In the deposition mask according to the first embodiment, in order to solve the above problem, heights of small surface holes in the first direction and in the second direction are formed to be different.

Referring to FIGS. 6 to 8, the unit through-hole UTH has a height H2-1 of the first small surface hole and a height H2-2 of the second small surface hole. The height H2-1 of the first small surface hole is a height in the first direction 1D. The height H2-2 of the second small surface hole is a height in the second direction 2D. The height H2-1 of the first small surface hole and the height H2-2 of the second small surface hole are different. The height H2-1 of the first small surface hole and the height H2-2 of the second small surface hole are respectively defined as heights from the connecting portion CA to the first surface 1S of the metal plate.

In detail, the height H2-2 of the second small surface hole is smaller than the height H2-1 of the first small surface hole.

In detail, the height H2-1 of the first small surface hole and the height H2-2 of the second small surface hole may be 1 µm to 5 µm. In more detail, the height H2-1 of the first small surface hole and the height H2-2 of the second small surface hole may be 1 µm to 4 µm. In more detail, the height H2-1 of the first small surface hole and the height H2-2 of the second small surface hole may be 1 µm to 3 µm.

Accordingly, the distance between one surface of the deposition mask 100 and the deposition substrate is reduced. Accordingly, deposition defects due to shadow effects may be reduced. For example, when forming an RGB pattern using the deposition mask 100, it is possible to prevent other deposition materials from being deposited in a region between two adjacent patterns.

Within the above range, the height H2-2 of the second small surface hole is smaller than the height H2-1 of the first small surface hole.

Therefore, the height H1-1 of the first large surface hole is smaller than the height H1-2 of the second large surface hole, and the height H2-1 of the first small surface hole is greater than the height H2-2 of the second small surface hole.

Accordingly, strength of the deposition mask may be uniform in the first direction and the second direction. Accordingly, it is possible to prevent the deposition mask from being bent in one direction. That is, the areas of the metal plates in the first direction and the second direction remaining above and below the metal plate become similar. Therefore, the strength of the metal plate may be uniform regardless of the direction.

Further, although the first inclination angle is smaller than the second inclination angle, the height of the first small surface hole is greater than the height of the second small surface hole.

Accordingly, it is possible to prevent the deposition of the deposition mask from being different in the first direction and the second direction. Accordingly, deposition efficiency of the deposition mask may be improved.

The deposition mask according to the first embodiment includes unit through-holes. The unit through-hole has different widths in the first and second directions.

Accordingly, the large surface holes of the unit through-holes may have different heights and inclination angles in the first and second directions. Accordingly, deposition efficiency of the deposition mask may decrease. In addition, since the strength of the deposition mask varies depending on the direction, the deposition mask may be bent in one direction.

Therefore, in the deposition mask according to the first embodiment, the height of the small surface hole is different depending on the direction. In detail, the height of the small surface hole is large in a direction where the height of the large surface hole is small. Further, the height of the small surface hole is small in a direction where the height of the large surface hole is large. Accordingly, it is prevented that the strength of the deposition mask varies depending on the direction.

Further, the height of the small surface hole is large in a direction where the inclination angle of the large surface hole is small. Further, the height of the small surface hole is small in the where the inclination angle of the large surface hole is large. Accordingly, deposition uniformity of the deposition mask is improved.

Therefore, the deposition mask according to the first embodiment has improved deposition efficiency and reliability.

Meanwhile, in the previous description, the rib is disposed between the unit through-holes adjacent in the long width direction of the unit through-hole, and the island portion is disposed between the unit through-holes adjacent in the short width direction of the unit through-hole. However, the embodiment is not limited thereto.

That is, island portions may be disposed between unit through-holes adjacent to each other in the long width direction of the unit through-hole. In addition, ribs may be disposed between unit through-holes adjacent in a short width direction of the unit through-hole.

In this case, the height H2-1 of the first small surface hole is smaller than the height H2-2 of the second small surface hole. In addition, the same effect as above may be obtained by making the first inclination angle θ1 larger than the second inclination angle θ2.

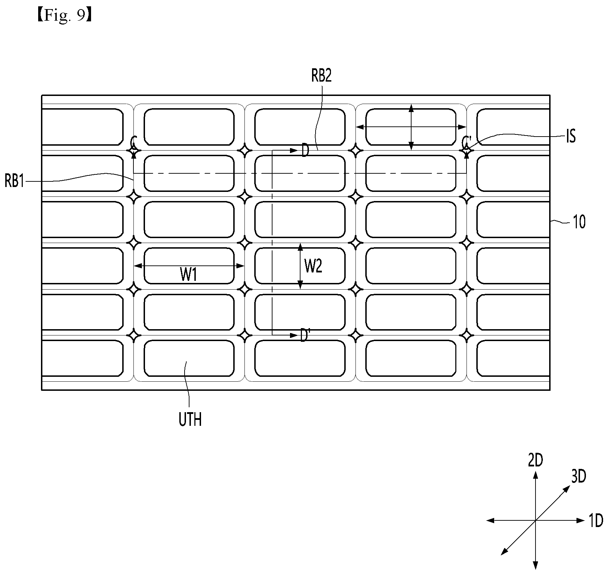

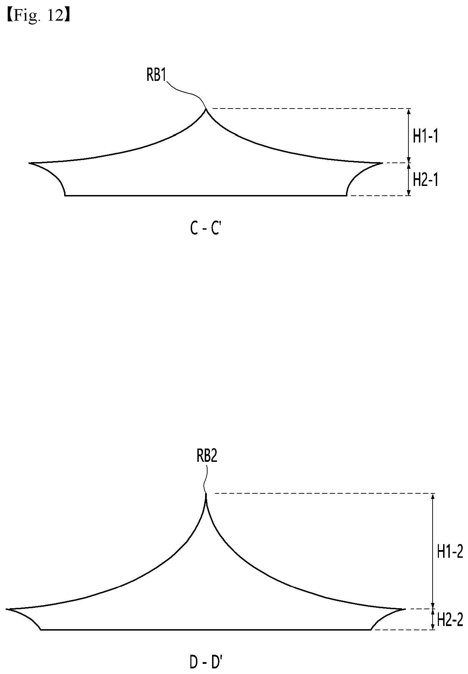

Hereinafter, a deposition mask according to a second embodiment will be described with reference to FIGS. 9 to 12. In the description of the deposition mask according to the second embodiment, descriptions identical to or similar to those of the deposition mask according to the first embodiment described above will be omitted. In addition, the same reference numerals are assigned to components identical to those of the deposition mask according to the first embodiment described above.

Referring to FIGS. 9 to 12, the deposition mask 100 includes a plurality of through-holes. In detail, the deposition mask 100 includes a plurality of unit through-holes UTH. The unit through-hole UTH is formed by the small surface hole V1, the large surface hole V2 and the connection portion CA.

The unit through-hole UTH includes the first width W1 in the first direction 1D and the second width W2 in the second direction 2D. The first direction 1D and the second direction 2D may be the longitudinal direction or the width direction of the deposition mask 100. For example, the first direction 1D may be the longitudinal direction of the deposition mask 100. Also, the second direction 2D may be the width direction of the deposition mask 100. In addition, the size of the width is defined as the size of the width of the large surface hole V2.

The first width W1 and the second width W2 are different. For example, the first width W1 is greater than the second width W2. Accordingly, the unit through-hole UTH has the long width in the first direction and the short width in the second direction.

The rib RB and the island portion IS are disposed between the plurality of unit through-holes UTH. The rib RB is the region where the metal plate 10 is partially etched. In addition, the island portion IS is the area where the metal plate 10 is not etched.

A first rib RB1 is disposed between unit through-holes UTH adjacent in the first direction 1D. In addition, a second rib RB2 is disposed between unit through-holes UTH adjacent in the second direction 2D. In addition, the island portion IS is disposed between unit through-holes UTH adjacent in the third direction 3D. the third direction 3D is a direction between the first direction 1D and the second direction 2D.

The first rib RB1 and the second rib RB2 connect the adjacent island portions IS.

The first rib RB 1 and the second rib RB2 extend in different directions. In detail, the first rib RB 1 extends in the second direction 2D. Also, the second rib RB2 extends in the first direction 1D.

A width W3 of the large surface hole V2 between the first ribs RB1 and the width W4 of the large surface hole V2 between the second ribs RB2 are different. In detail, the width W3 of the large surface hole V2 between the first ribs RB1 is greater than the width W4 of the large surface hole V2 between the second ribs RB2.

Accordingly, the amount of the organic material entering the large surface hole in the first direction and the amount of the organic material entering the large surface hole in the second direction are different. Accordingly, when the heights of the small surface holes in the first direction and the second direction are the same, the organic layer deposited on the deposition substrate may have different thicknesses in each direction. Accordingly, the deposition efficiency of the deposition mask may decrease.

In addition, since the width of the large surface hole between the first ribs in the second direction is different from the width of the large surface hole between the second ribs in the first direction, the remaining area of the metal plate in the first direction and the second direction is different. Therefore, the strength of the deposition mask is different in the first direction and the second direction. Accordingly, since the strength of the deposition mask varies depending on the direction, the deposition mask may be bent in one direction.

In the deposition mask according to the second embodiment, in order to solve the above problem, the height of the large surface hole and the height of the small surface hole in the first direction and the second direction are different.

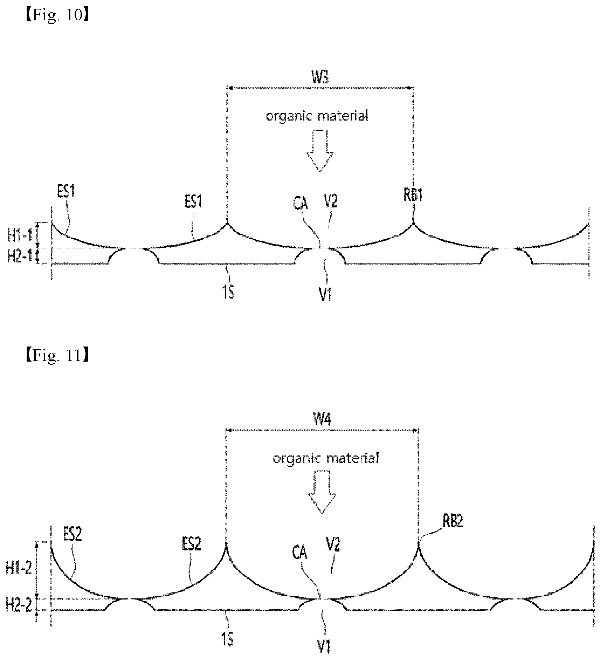

Referring to FIGS 10 to 12, the unit through-hole UTH has the height H1-1 of the first large surface hole and the height H1-2 of the second large surface hole. The height H1-1 of the first large surface hole is the height in the first direction. The height H1-2 of the second large surface hole is the height in the second direction. The height H1-1 of the first large surface hole is the height from the connecting portion CA to the first rib RB 1. In addition, the height H1-2 of the second large surface hole is the height from the connecting portion CA to the second rib RB2.

The height H1-1 of the first large surface hole and the height H1-2 of the second large surface hole are different. In detail, the height H1-2 of the second large surface hole is greater than the height H1-1 of the first large surface hole.

Accordingly, the unit through-hole may accommodate a sufficient amount of organic material in the large surface hole in the second direction. That is, the width W4 of the large surface hole between the second ribs RB2 is greater than the width W3 of the large surface hole between the first ribs RB1. Accordingly, the area for accommodating the organic material in the large surface hole in the second direction 2D is reduced by the width of the large surface hole between the second ribs RB2. Therefore, the height H1-2 of the second large surface hole is greater than the height H1-1 of the first large surface hole. As a result, the large surface hole in the second direction 2D may secure an area for accommodating the organic material.

Also, referring to FIGS. 10 to 12, the unit through-hole UTH has the height H2-1 of the first small surface hole and the height H2-2 of the second small surface hole. The height H2-1 of the first small surface hole is the height in the first direction 1D. The height H2-2 of the second small surface hole is the height in the second direction 2D. The height H2-1 of the first small surface hole and the height H2-2 of the second small surface hole are different. The height H2-1 of the first small surface hole and the height H2-2 of the second small surface hole are heights from the connection portion CA to the first surface 1S of the metal plate, respectively.

In detail, the height H2-2 of the second small surface hole is smaller than the height H2-1 of the first small surface hole.

In detail, the height H2-1 of the first small surface hole and the height H2-2 of the second small surface hole may be 1 µm to 5 µm. In more detail, the height H2-1 of the first small surface hole and the height H2-2 of the second small hole may be 1 µm to 4 µm. In more detail, the height H2-1 of the first small surface hole and the height H2-2 of the second small surface hole may be 1 µm to 3 µm.

Within the above range, the height H2-2 of the second small surface hole is smaller than the height H2-1 of the first small surface hole.

Therefore, the width W3 of the large surface hole between the first ribs RB1 in the first direction 1D is greater than the width W4 of the large surface hole between the second ribs RB2 in the second direction 2D. In addition, the height H2-1 of the first small surface hole is greater than the height H2-2 of the second small surface hole height.

Accordingly, strength of the deposition mask may be uniform in the first and second directions. Accordingly, it is possible to prevent the deposition mask from being bent in one direction. That is, the areas of the metal plates in the first direction and the second direction remaining above and below the metal plate become similar. Therefore, the strength of the metal plate may be uniform regardless of the direction.

The deposition mask according to the second embodiment includes unit through-holes. The unit through-hole has different widths in the first direction and in the second direction. In addition, ribs having different widths in the first and second directions are disposed between adjacent unit through-holes.

Accordingly, deposition uniformity of the deposition mask may be reduced. In addition, the strength of the deposition mask may vary depending on the direction.

Therefore, the height of the small surface hole and the large surface hole are different depending on the direction. In detail, the height of the large surface hole is small in a direction where the width of the rib is small. In addition, the height of the small surface hole is large in a direction where the width of the rib is small. In addition, the height of the large surface hole is large in a direction where the width of the rib is large. In addition, the height of the small surface hole is small in a direction where the width of the rib is large.

Accordingly, it is possible to prevent the strength of the deposition mask from being varied depending on the direction. In addition, a sufficient amount of organic material can be accommodated in the large surface hole having a large width of the rib.

Therefore, the deposition mask according to the second embodiment has improved deposition efficiency and reliability.

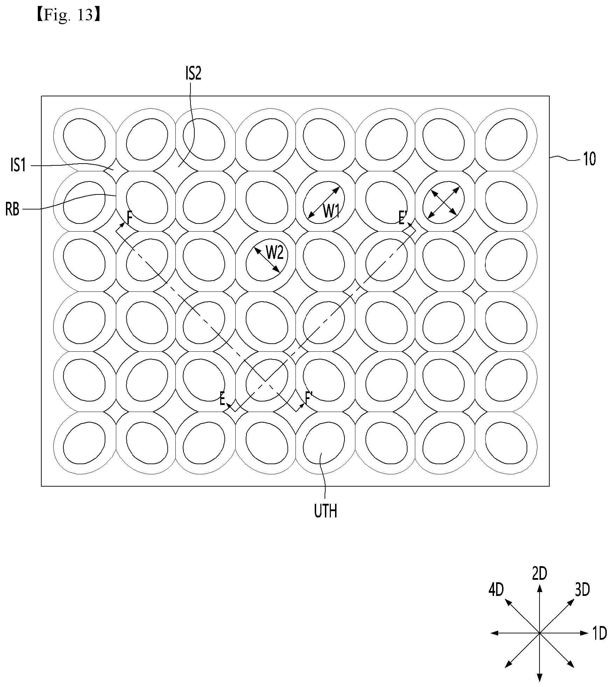

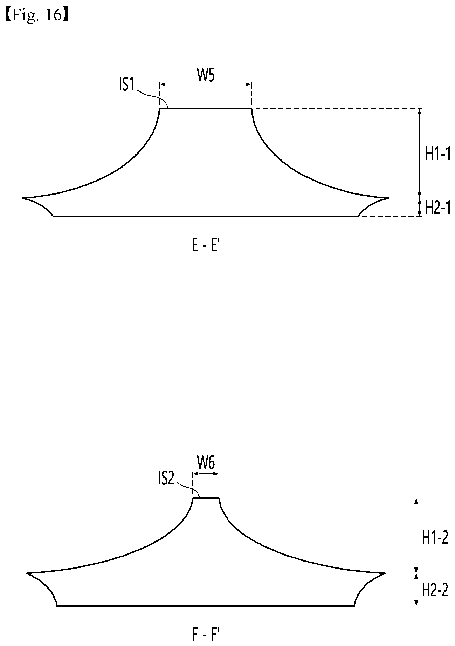

Hereinafter, a deposition mask according to a third embodiment will be described with reference to FIGS. 13 to 16. In the description of the deposition mask according to the third embodiment, descriptions identical to or similar to those of the deposition mask according to the embodiments described above will be omitted. In addition, the same reference numerals are assigned to components identical to those of the deposition mask according to the embodiments described above.

Referring to FIGS. 13 to 16, the deposition mask 100 includes a plurality of through-holes. In detail, the deposition mask 100 includes a plurality of unit through-holes UTH. The unit through-hole UTH is formed by the small surface hole V1, the large surface hole V2 and the connection portion CA.

The unit through-hole UTH has a first width W1 in the third direction 3D and a second width W2 in the fourth direction 4D. The third direction 3D is one diagonal direction of the deposition mask 100. The fourth direction 4D is another diagonal direction of the deposition mask 100. In addition, the size of the width is defined as the size of the width of the large surface hole V2.

The first width W1 and the second width W2 are different. For example, the first width W1 is greater than the second width W2. Accordingly, the unit through-hole UTH has a long width in the first direction and a short width in the second direction.

Ribs RB and island portions IS1 and IS2 are disposed between the plurality of unit through-holes UTH. The rib RB is a region where the metal plate 10 is partially etched. In addition, the island portions IS1 and IS2 are regions in which the metal plate 10 is not etched.

A first island portion IS1 is disposed between unit through-holes UTH adjacent in the third direction 3D. A second island portion IS2 is disposed between the unit through-holes UTH adjacent in the fourth direction 4D. The rib RB is disposed between unit through-holes UTH adjacent in the first direction 1D and the second direction 2D.

The rib RB connects the adjacent island portions IS1 and IS2.

A width W5 of the first island portion IS1 is different from a width W6 of the second island portion IS2. In detail, the width W5 of the first island portion IS1 is greater than the width W6 of the second island portion IS2. Alternatively, the area of the first island portion IS1 and the area of the second island portion IS2 are different from each other. In detail, the area of the first island portion IS1 is larger than that of the second island portion IS2.

Accordingly, the amount of the organic material entering the large surface hole in the third direction and the amount of the organic material entering the large surface hole in the fourth direction are different. Accordingly, when the heights of the small surface holes in the third and fourth directions are the same, the organic layer deposited on the deposition substrate may have different thicknesses in each direction. Accordingly, deposition efficiency of the deposition mask may decrease.

In addition, since the first island portion and the second island portion have different widths and/or areas, remaining areas of the metal plates in the third and fourth directions are different. Accordingly, the strength of the deposition mask is different in the third and fourth directions. Accordingly, since the strength of the deposition mask varies depending on the direction, the deposition mask may be bent in one direction.

In the deposition mask according to the third embodiment, in order to solve the above problem, the height of the large surface hole and the height of the small face hole in the first direction and the second direction are different.

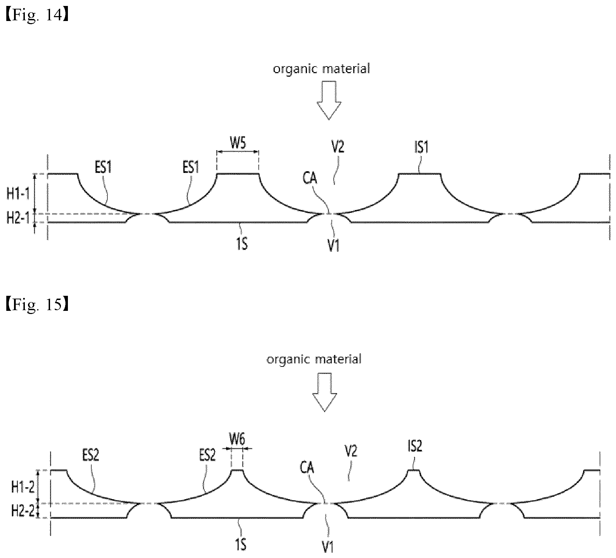

Referring to FIGS. 14 to 16, the unit through-hole UTH has a height H1-1 of the first large surface hole and a height H1-2 of the second large surface hole height. The height H1-1 of the first large surface hole is the height in the third direction. The height H1-2 of the second large surface hole is the height in the fourth direction. The height H1-1 of the first large surface hole is the height from the connecting portion CA to the first island portion IS1. In addition, the height H1-2 of the second large surface hole is the height from the connecting portion CA to the second island portion IS2.

The height H1-1 of the first large surface hole and the height H1-2 of the second large surface hole are different. In detail, the height H1-1 of the first large surface hole is greater than the height H1-2 of the second large surface hole.

Accordingly, the unit through-hole may accommodate a sufficient amount of organic material in the large surface hole in the third direction 3D. That is, the width W5 and/or area of the first island portion IS1 is larger than the width W6 and/or area of the second island portion IS2. Accordingly, the area for accommodating the organic material in the large surface hole in the third direction 3D is reduced by the width W5 and/or the area of the first island portion IS1. Therefore, the height H1-1 of the first large surface hole is greater than the height H1-2 of the second large surface hole. Accordingly, the large surface hole in the third direction 3D may secure an area where the organic material is accommodated.

Also, referring to FIGS. 14 to 16, the unit through-hole UTH has a height H2-1 of the first small surface hole and a height H2-2 of the second small surface hole. The height H2-1 of the first small surface hole is the height in the third direction 3D. The height H2-2 of the second small surface hole is the height in the fourth direction 4D. The height H2-1 of the first small surface hole and the height H2-2 of the second small surface hole are different. The height H2-1 of the first small surface hole and the height H2-2 of the second small surface hole are heights from the connection portion CA to the first surface 1S of the metal plate, respectively.

In detail, the height H2-1 of the first small surface hole is smaller than the height H2-2 of the second small surface hole.

In detail, the height H2-1 of the first small surface hole and the height H2-2 of the second small surface hole may be 1 µm to 5 µm. In more detail, the height H2-1 of the first small surface hole and the height H2-2 of the second small surface hole may be 1 µm to 4 µm. In more detail, the height H2-1 of the first small surface hole and the height H2-2 of the second small surface hole may be 1 µm to 3 µm.

Within the above range, the height H2-1 of the first small surface hole is smaller than the height H2-2 of the second small surface hole.

Accordingly, the width W6 of the second island portion IS2 in the fourth direction 4D is smaller than the width W5 of the first island portion IS1 in the third direction 3D. Further, the height H2-2 of the second small surface is greater than the height H2-1 of the first small surface.

Accordingly, the strength of the deposition mask may be uniform in the third direction 3D and the fourth direction 4D. Accordingly, it is possible to prevent the deposition mask 100 from being bent in one direction. That is, the areas of the metal plates in the third and fourth directions remaining above and below the metal plate become similar. Therefore, the strength of the metal plate can be uniform regardless of the direction.

The deposition mask according to the third embodiment includes unit through-holes. The unit through-holes have different widths in the third and fourth directions. In addition, island portions having different widths and/or areas in the third and fourth directions are disposed between adjacent unit through-holes.

Accordingly, deposition uniformity of the deposition mask may be reduced. In addition, the strength of the deposition mask may vary depending on the direction.

Therefore, the height of the small surface hole and the large surface hole are different depending on the direction. In detail, the height of the large surface hole is small in a direction where the width and/or area of the island portion is small. In addition, the height of the small surface hole is large in a direction where the width and/or area of the island portion is small. In addition, the height of the large surface hole is large in a direction where the width and/or area of the island portion is large. In addition, the height of the small surface hole is small in a direction where the width and/or area of the island portion is large.

Accordingly, it is possible to prevent the strength of the deposition mask from being varied depending on the direction. In addition, a sufficient amount of organic material can be accommodated in the large surface hole having a large width and/or area of the island portion.

Therefore, the deposition mask according to the third embodiment has improved deposition efficiency and reliability.

Meanwhile, in the previous description, the width and/or area of the first island portion between unit through-holes adjacent in the long width direction of the unit through-hole is larger than the width and/or area of the second island portion between unit through-holes adjacent in the short width direction of the unit through-hole was described. However, the embodiment is not limited thereto.

That is, the width and/or area of the first island portion between unit through-holes adjacent in the long width direction of the unit through-hole is smaller than the width and/or area of the second island portion between unit through-holes adjacent in the short width direction of the unit through-hole.

In this case, the height H1-2 of the second large surface hole is greater than the height H1-1 of the first large surface hole. In addition, the same effect as above may be obtained by making the height H1-2 of the second large surface hole smaller than the height H1-1 of the first large surface hole.

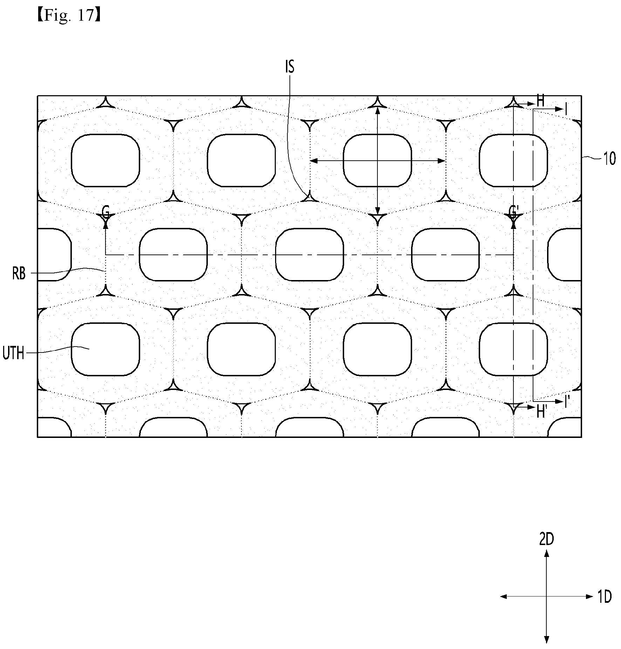

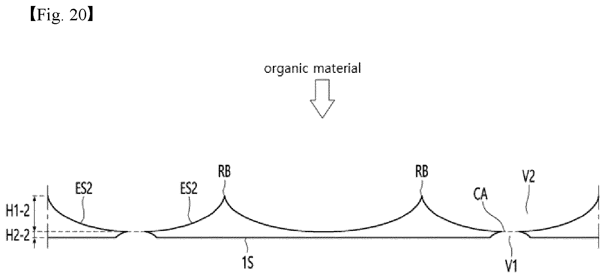

Hereinafter, a deposition mask according to a fourth embodiment will be described with reference to FIGS. 17 to 20. In the description of the deposition mask according to the fourth embodiment, descriptions identical to or similar to those of the deposition mask according to the embodiments described above will be omitted. In addition, the same reference numerals are assigned to components identical to those of the deposition mask according to the embodiments described above.

Referring to FIGS. 17 to 20, the deposition mask 100 according to the fourth embodiment includes a plurality of through-holes. In detail, the deposition mask 100 includes a plurality of unit through-holes UTH. The unit through-hole UTH is formed by the small surface hole V1, the large surface hole V2 and the connection portion CA.

The unit through-hole UTH includes a first width W1 in a first direction 1D and a second width W2 in a second direction 2D. The first direction 1D may be a longitudinal direction of the deposition mask 100. Also, the second direction 2D may be a width direction of the deposition mask 100. In addition, the size of the width is defined as the size of the width of the large surface hole V2.

The first width W1 and the second width W2 are different. For example, the first width W1 is greater than the second width W2. Accordingly, the unit through-hole UTH has a long width in the first direction and a short width in the second direction.

A rib RB and an island portion IS are disposed between the plurality of unit through-holes UTH. The rib RB is a region where the metal plate 10 is partially etched. In addition, the island portion IS is an area where the metal plate 10 is not etched.

The rib RB is disposed between unit through-holes UTH adjacent in the first direction 1D. The rib RB and the island portion IS are disposed between the unit through-holes UTH adjacent in the second direction 2D. In detail, both the rib RB and the island portion IS are disposed in one region among the regions between the unit through-holes UTH adjacent in the second direction 2D. In addition, only ribs RB are disposed in other region among regions between unit through-holes UTH adjacent in the second direction 2D.

In addition, one rib RB is disposed between unit through-holes UTH adjacent in the first direction 1D. In addition, at least one rib RB is disposed in another region among region s between unit through-holes UTH adjacent in the second direction 2D. In detail, a plurality of ribs RB are disposed in another region among region s between unit through-holes UTH adjacent in the second direction 2D.

Accordingly, the remaining area of the metal plate in the first direction and the second direction is different. That is, only one rib is disposed between unit through-holes UTH adjacent in the first direction 1D. On the other hand, a plurality of island portions and a plurality of ribs are disposed between the unit through-holes UTH adjacent in the second direction 2D.

Accordingly, the remaining area of the metal plate in the first direction and the second direction is different. Accordingly, the strength of the deposition mask is different in the first direction and the second direction. Accordingly, since the strength of the deposition mask varies depending on the direction, the deposition mask may be bent in one direction.

In the deposition mask according to the fourth embodiment, in order to solve the above problem, heights of small surface holes in the first direction and in the second direction are formed to be different.

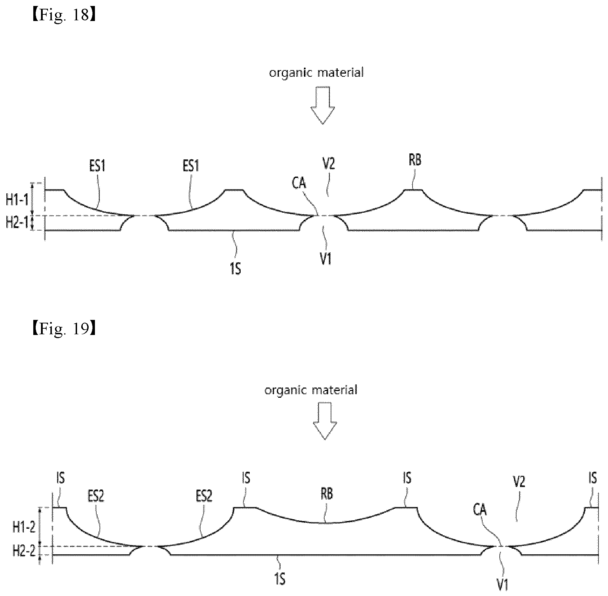

Referring to FIGS. 18 to 20, the unit through-hole UTH has a height H2-1 of the first small surface hole and a height H2-2 of the second small surface hole. The height H2-1 of the first small surface hole is the height in the first direction 1D. The height H2-2 of the second small surface hole is the height in the second direction 2D. The height H2-1 of the first small surface hole and the height H2-2 of the second small surface hole are different. The height H2-1 of the first small surface hole and the height H2-2 of the second small surface hole are heights from the connection portion CA to the first surface 1S of the metal plate, respectively.

In detail, the height H2-2 of the second small surface hole is smaller than the height H2-1 of the first small surface hole.

In detail, the height H2-1 of the first small surface hole and the height H2-2 of the second small surface hole may be 1 µm to 5 µm. In more detail, the height H2-1 of the first small surface hole and the height H2-2 of the second small surface hole may be 1 µm to 4 µm. In more detail, the height H2-1 of the first small surface hole and the height H2-2 of the second small surface hole may be 1 µm to 3 µm.

Within the above range, the height H2-2 of the second small surface is smaller than the height H2-1 of the first small surface.

Accordingly, strength of the deposition mask may be uniform in the first direction and the second direction. Accordingly, it is possible to prevent the deposition mask from being bent in one direction. That is, the difference between the areas of the metal plates in the first and second directions remaining above and below the metal plate is reduced. Therefore, the strength of the metal plate can be uniform regardless of the direction.

Meanwhile, in the previous description, one rib is disposed between unit through-holes adjacent in the long width direction of the unit through-hole, and a plurality of island portions and a plurality of ribs are disposed between unit through-holes adjacent in the short width direction of the unit through-hole was described. However, the embodiment is not limited thereto.

That is, one rib may be disposed between unit through-holes adjacent in the short width direction of the unit through-hole. In addition, a plurality of island portions and a plurality of ribs may be disposed between unit through-holes adjacent in the long width direction of the unit through-hole.

In this case, the same effect as above may be obtained by making the height H2-2 of the second small surface hole larger than the height H2-1 of the first small surface hole.

In addition, in the previous description, one rib is disposed between unit through-holes adjacent in the long width direction of the unit through-hole, and a plurality of island portions and a plurality of ribs are disposed between unit through-holes adjacent in the short width direction of the unit through-hole was described. However, the embodiment is not limited thereto.

That is, one rib and one island portion may be disposed between unit through-holes adjacent in the short width direction of the unit through-hole. In addition, a plurality of island portions and a plurality of ribs may be disposed between unit through-holes adjacent in the long width direction of the unit through-hole.

In this case, the same effect as above may be obtained by making the height H2-1 of the first small surface hole larger than the height H2-2 of the second small surface hole.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A deposition mask comprising;
a metal plate including a deposition region and a non-deposition region,
wherein the deposition region includes at least one effective portion;
wherein the effective portion includes a plurality of unit through-holes,
wherein the unit through-holes include a small surface hole formed on a first surface of the metal plate; a large surface hole formed on a second surface of the metal plate; and a connecting portion connecting the small surface hole and the large surface hole,
wherein the unit through-hole includes a first width defined as a width in a first direction; and a second width defined as a width in a second direction,
wherein the first width and the second width are different,
wherein a rib is disposed between unit through-holes adjacent in the first direction,
wherein an island portion is disposed between the unit through-holes adjacent in the second direction,
wherein a height of the small surface hole of the unit through-hole in the second direction is smaller than a height of the small surface hole of the unit through-hole in the first direction.

2. The deposition mask of claim 1, in the unit through-hole, a first inclination angle of the first inner surface of the large surface hole in the first direction is smaller than a second inclination angle of the second inner surface of the large surface hole in the second direction.

3. The deposition mask of claim 1 or 2, wherein the first direction is defined as a longitudinal direction of the deposition mask,
wherein the second direction is defined as a width direction of the deposition mask,
wherein the first width is greater than the second width.

4. The deposition mask of claim 1 or 2,
The deposition mask of claim 1 or 2, wherein the first direction is defined as a longitudinal direction of the deposition mask,
wherein the second direction is defined as a width direction of the deposition mask,
wherein the second width is greater than the first width.

5. A deposition mask comprising;
a metal plate including a deposition region and a non-deposition region,
wherein the deposition region includes at least one effective portion;
wherein the effective portion includes a plurality of unit through-holes,
wherein the unit through-holes include a small surface hole formed on a first surface of the metal plate; a large surface hole formed on a second surface of the metal plate; and a connecting portion connecting the small surface hole and the large surface hole,
wherein the unit through-hole includes a first width defined as a width in a first direction; and a second width defined as a width in a second direction,
wherein the first width and the second width are different,
wherein a first rib is disposed between unit through-holes adjacent in the first direction;
wherein a second rib is disposed between unit through-holes adjacent in the second direction,
wherein a width of the large surface hole between the first ribs is greater than a width of the large surface hole between the second ribs,
In the unit through-hole, the height of the carding hole in the second direction is smaller than the height of the carding hole in the first direction.
wherein a height of the small surface hole of the unit through-hole in the second direction is smaller than a height of the small surface hole of the unit through-hole in the first direction.

6. The deposition mask of claim 5, wherein the first rib and the second rib extend in different directions.

7. A deposition mask comprising;
a metal plate including a deposition region and a non-deposition region,
wherein the deposition region includes at least one effective portion;
wherein the effective portion includes a plurality of unit through-holes,
wherein the unit through-holes include a small surface hole formed on a first surface of the metal plate; a large surface hole formed on a second surface of the metal plate; and a connecting portion connecting the small surface hole and the large surface hole,
wherein the unit through-hole includes a first width defined as a width in a third direction; and a second width defined as a width in a fourth direction,
wherein the first width and the second width are different,
wherein a first island portion is disposed between unit through-holes adjacent in the third direction;
wherein a second island portion is disposed between the unit through-holes adjacent in the fourth direction,
wherein a width of the first island portion is greater than a width of the second island portion,
wherein a height of the small surface hole in the third direction is smaller than the height of the small surface hall in the fourth direction.

8. The deposition mask of claim 7, wherein an area of the first island portion is greater than an area of the second island portion.

9. A deposition mask comprising;
a metal plate including a deposition region and a non-deposition region,
wherein the deposition region includes at least one effective portion;
wherein the effective portion includes a plurality of unit through-holes,
wherein the unit through-holes include a small surface hole formed on a first surface of the metal plate; a large surface hole formed on a second surface of the metal plate; and a connecting portion connecting the small surface hole and the large surface hole,
wherein the unit through-hole includes a first width defined as a width in a first direction; and a second width defined as a width in a second direction,
wherein the first width and the second width are different,
wherein a rib is disposed between unit through-holes adjacent in the first direction,
wherein a rib and an island portion are disposed between the unit through-holes adjacent in the second direction,
wherein a height of the small surface hole of the unit through-hole in the second direction is smaller than a height of the small surface hole of the unit through-hole in the first direction.

10. The deposition mask of claim 9, wherein the rib and the island portion are disposed in one region among regions between the unit through-holes adjacent in the second direction,
wherein at least one rib is disposed in another region among regions between unit through-holes adjacent in the second direction.
